# EUROPEAN PATENT APPLICATION

(11) **EP 2 811 308 A1**
(43) Date of publication of application: **10.12.2014**
(21) Application number: 14170824.8
(22) Date of filing: 02.06.2014
(51) Int. Cl.: G01R 31/317, G01R 31/3193, G06F 13/00, G06K 7/00

(54) **Method and system for tracing and processing smart card interactive data**

(30) Priority: 04.06.2013 CN 201310218007; 26.12.2013 CN 201310730705
(71) Applicant: Eastcompeace Technology Co. Ltd, Guangdong 519060 (CN)
(72) Inventor: Zhou, Zhongguo, 519060 Zhuhai (CN); Huang, Xiaopeng, 519060 Zhuhai (CN); Chang, Mingtao, 519060 Zhuhai (CN); Zhang, Liuyi, 519060 Zhuhai (CN); Shi, Weizhou, 519060 Zhuhai (CN); Liu, Gangyi, 519060 Zhuhai (CN); Zhang, Hanjiu, 519060 Zhuhai (CN)
(74) Representative: Arpe Fernandez, Manuel de

(57) **Abstract**

The invention provides a method for tracing and processing smart card interactive data comprising the following steps: S1. monitoring and collecting original interactive data of respective contacts VCC/IO/RST/CLK of smart card; S2. parsing the original data into smart card communication protocol byte stream; S3. organizing the communication protocol byte stream into communication protocol data sequence; S4. displaying the protocol data sequence to users of system; S5. saving the communication protocol data sequence; S6. converting he communication protocol data sequence into smart card instruction sequence; S7. performing the smart card instruction sequence, rapidly testing cards of the same category and then terminating current tracing. Between the S1 and the termination of current tracing, there are further comprised the following two simultaneously performed tasks: Sm. plotting waveform diagram of smart card interactive data based on the original interactive data and displaying it; Sn. incrementally saving the original interactive data. The invention may achieve the aim of completely recreating field test to better analyze and solve problems.

## Description

### FIELD OF THE INVENTION

The present invention relates to the field of mobile communication, and particularly to a method and system for tracing and processing smart card interactive data.

### BACKGROUND OF THE INVENTION

With the advent of the Internet age, application occasion of universal integrated circuit card (UICC) is more and more and is more and more complicated, such as mobile phone field, mobile payment field and financial IC card field and so on. UICC card is a mobile smart card which is used for storing user information, authentication key, telephone directory, short message and the like. Users only need to take UICC card out from one terminal and insert it into another terminal to be able to easily transmit users' subscription information from one terminal to another terminal. Smart card is a chip containing an integrated circuit meeting up with ISO standard. Smart card includes a microprocessor, an I/O interface and a memory for providing data calculation, access control and storage functions and is also referred to as an "Integrated Circuit card". The English name is "Integrated Circuit Card" or "Smart Card". Smart card is an ultra-miniature computer synergistically working with smart card terminal, smart card reader and its application software to achieve certain functions (such as calling, sending message and swiping card to consume). When these functions fail and they cannot be achieved, how to do? How to discover and solve these problems?

Presently, there are mainly two methods for analyzing and solving communication failure or compatibility problem of the smart card and its interactive equipment:
Method 1: research and development personnel of the smart card and respective suppliers of interactive equipment thereof carefully study or discuss corresponding protocol and specification again, each find problems of their own, guess likely conditions in light of problems and phenomena and retest after variations are made until the problem is solved.
Method 2: variation in electrical signal occurred when the smart card and its interactive equipment interact is observed by the use of a general oscilloscope and thereby the likely reason is judged and solved.

The above methods have the following drawbacks:
Method 1 significantly depends on personal experience and competence of the research and development personnel. For difficult problem, many modifications and attempts are often needed to be able to find and solve problems. The oscilloscope used in Method 2 is typically heavy to carry and has some difficulties in use and thus it is not suitable to be used by the ordinary technical support person in failure site.

In addition, SIM card (SIM card is one application of UICC card) and mobile terminal are taken as an example. In order to guarantee that SIM card and mobile terminal can normally perform a data interaction, the data interaction between SIM card and mobile terminal is required to be monitored. SIM card and mobile terminal generally perform a data interaction through interfaces of ISOIEC7816-3. In the prior art, in the process of monitoring data interaction between SIM card and mobile terminal, when levels of the interface of 7816-CLK and the interface of 7816-IO have variations, a processor samples the interface of 7816-CLK and the interface of 7816-IO whose level has been varied three times through its internal timer. If the sampled level is varied twice, it is considered to be one state. The collected data is stored in external memory and sent when free to terminal equipment to be analyzed and processed.

The method used in the prior art for monitoring data interaction of the interfaces of ISOIEC7816-3 can only monitor variations in levels of 7816-CLK interface and 7816-IO interface. Correspondingly, it is only able to collect data of 7816-CLK interface and 7816-IO interface. Incompleteness of the collected data significantly influences the subsequent analysis and processing of data.

It is not hard to see that there exist certain drawbacks in the prior art.

### SUMMARY OF THE INVENTION

In view of this, aiming at the problem proposed in the background, it is necessary to provide a new method and system for tracing and processing smart card interactive data which may rapidly find problems.

In order to achieve the above aim, the invention provides the following technical scheme.

A method for tracing and processing smart card interactive data includes the following steps:
S1. monitoring and collecting original interactive data of respective contacts VCC/IO/RST/CLK of smart card;
S2. parsing the original data into smart card communication protocol byte stream;
S3. organizing the communication protocol byte stream into communication protocol data sequence;
S4. displaying the protocol data sequence to users of system;
S5. saving the communication protocol data sequence;
S6. converting he communication protocol data sequence into smart card instruction sequence;
S7. performing the smart card instruction sequence, rapidly testing cards of the same category and then terminating current tracing.

Between the S1 and the termination of current tracing, there are further included the following two simultaneously performed tasks:
Sm. plotting waveform diagram of smart card interactive data based on the original interactive data and displaying it;
Sn. incrementally saving the original interactive data.

Further, the S1 includes setting collection rule of smart card original interactive data, monitoring and collecting original interactive data of respective contacts VCC/IO/RST/CLK of smart card, wherein data of VCC contact includes jump direction of VCC signal and cumulative time value, data of IO contact includes jump direction of IO signal, category in which smart card falls in (category A/B/C card), number of sustaining CLK and cumulative time value, data of RST contact includes jump direction of RST signal and cumulative time value, and data of CLK contact includes jump direction of CLK signal, identification of the start and failure of oscillation and cumulative time value.

Further, the Sm includes plotting the original interactive data respectively in terms of VCC/IO/RST/CLK into waveform diagram and displaying it in waveform diagram display area, and writing communication protocol byte in the corresponding location of the waveform diagram.

Further, the Sn includes incrementally saving the original interactive data in the form of binary file.

Further, the S5 particularly includes determining whether there is a need to save the communication protocol data sequence, if there being no such need, terminating current tracing, if there being such a need, saving it as text file. The S6 particularly includes determining whether there is a need to convert protocol data sequence into smart card instruction sequence, if there being no such need, terminating current tracing, if there being such a need, converting protocol data sequence into smart card instruction sequence and saving it for subsequent use. The S7 particularly includes determining whether there is a need to test cards of the same category, if there being no such need, terminating current tracing, if there being such a need, performing the smart card instruction sequence and rapidly testing cards of the same category.

A system for tracing and processing smart card interactive data includes a portable tracker used for monitoring and collecting original interactive data of respective contacts VCC/IO/RST/CLK of smart card;
an original data parsing module used for parsing the original data into smart card communication protocol byte stream of significance;
a waveform diagram plotting module used for plotting waveform diagram of smart card interactive data based on the original interactive data and displaying it;
a smart card protocol data organizing module used for organizing the communication protocol byte stream into easily understood communication protocol data sequence;
a protocol data displaying module used for displaying the protocol data sequence to users of the system;
a communication protocol data sequence saving module used for saving the communication protocol data sequence;
an interactive data saving module used for incrementally saving the original interactive data;
a protocol data converting module used for converting the communication protocol data sequence into smart card instruction sequence;
an instruction sequence performing module used for performing the smart card instruction sequence and rapidly testing cards of the same category.

Further, the portable tracker is particularly used for setting collection rule of smart card original interactive data, and monitoring and collecting original interactive data of respective contacts VCC/IO/RST/CLK of smart card, wherein data of VCC contact includes jump direction of VCC signal and cumulative time value, data of IO contact includes jump direction of IO signal, category in which smart card falls in (category A/B/C card), number of sustaining CLK and cumulative time value, data of RST contact includes jump direction of RST signal and cumulative time value, and data of CLK contact includes jump direction of CLK signal, identification of the start and failure of oscillation and cumulative time value.

Further, the waveform diagram plotting module is particularly used for plotting original interactive data respectively in terms of VCC/IO/RST/CLK into waveform diagram and displaying waveform diagram in the waveform diagram display area of the soft system of the invention, and writing communication protocol byte in the corresponding location of the waveform diagram.

Further, the original interactive data saving module is particularly used for incrementally saving the original interactive data in the form of binary file.

Further, the S5 includes determining whether there is a need to save the communication protocol data sequence, if there being no such need, current tracing being terminated, if there being such a need, the communication protocol data sequence being saved as text file by the interactive data saving module; a second determination module used for determining whether there is a need to convert protocol data sequence into smart card instruction sequence, if there being no such need, current tracing being terminated, if there being such a need, protocol data sequence being converted into smart card instruction sequence by the protocol data converting module and being saved for subsequent use; a third determination module used for determining whether there is a need to test cards of the same category, if there being no such need, current tracing being terminated, if there being such a need, the smart card instruction sequence is performed by the instruction sequence performing module and cards of the same category being rapidly tested.

Further, the portable tracker includes:
a first determination module used for determining whether a data collecting request is received and thus a first determination result being obtained, wherein the data collecting request is corresponding to 7816 interface whose signal has a variation for requesting the processor to perform a data collection on the 7816 interface whose signal has a variation;
an interface determining module used for determining 7816 interface required to be performed a data collection through the data collecting request when the first determination result indicates that data collecting request is received to cause data collecting module to collect data from the determined 7816 interface;
a data storing module used for storing data collected by the data collecting module from the determined 7816 interface;
a data transmitting module used for transmitting the stored data to terminal equipment to cause the terminal equipment to process the data.

Further, the data collecting request is an interrupt request sent by the universal input output interface GPIO of the processor to the processor when levels of 7816 interfaces have variations.

The first determination module includes:
a first determination child module used for determining whether interrupt request from GPIO of the processor is received and thus a first determination result being obtained.

The interface determining module includes:
an interface determining child module used for determining 7816 interface required to be performed a data collection through the interrupt request of GPIO when the first determination result indicates that the interrupt request from GPIO of the processor is received.

Further, inside the processor there is provided with a storage space serving to provide buffering for data transmission.

The data storing module includes:
a data storing child module used for storing the data collected by the data collecting module from the determined 7816 interface into the storage space provided in the processor serving to provide buffering for data transmission.

Further, the data transmitting module includes: a second determination child module used for determining whether there is data that has not been transmitted in the storage space and thus a second determination result being obtained;
a data transmitting child module used for transmitting the data that has not been transmitted in the storage space to terminal equipment when the second determination result indicates that there is data that has not been transmitted in the storage space.

The method and system for tracing and processing smart card interactive data provided by the invention may rapidly find problems. The portable tracker can solve the problem that the method used in the prior art for monitoring data interaction of interfaces of ISOIEC7816-3 can only monitor the data of 7816-CLK interface and 7816-IO interface thus incompleteness of the collected data significantly influences the subsequent analysis and processing of data.

Compared with the prior art, the invention has the following advantages:
After field technical support person find problems, using portable tracker and the method according to the invention to trace and analyze interactive data may not only feed back the traced protocol data sequence or smart card instruction sequence to product developer but also may feed back the above automatically saved original data to product developer. The product developer may have no support of hardware equipment, tracker, and by loading original trace data into the software system according to the invention, the product developer can obtain protocol data sequence or smart card instruction sequence, waveform diagram of respective contacts VCC/IO/RST/CLK of smart card through automatic analysis and process thus achieving the aim of completely recreating field test to better analyze and solve problems.

The data collected through the portable tracker provided by the invention is more complete, more fully and can more truly reflect the state of interfaces which is beneficial to the analysis and process of the subsequent data. In addition, the collected data being stored into the storage space provided in the processor serving to provide buffering for data transmission causes the transmission speed of data to be improved.

### BRIEF DESCRIPTION OF THE DRAWINGS

In order to more clearly illustrate technical schemes in embodiments of the invention or the prior art, accompanying drawings used in the description of the embodiments or the prior art will be simply introduced below. Obviously, the drawings in the following description are only some embodiments of the invention. For those ordinary skilled in the art, other drawings may also be obtained from these drawings under the premise that no creative work is done.
Figure 1 is a schematic flow diagram of a method for tracing and processing smart card interactive data provided by a first embodiment of the invention;
Figure 2 is a structural schematic view of a portable tracker provided by the first embodiment of the invention;

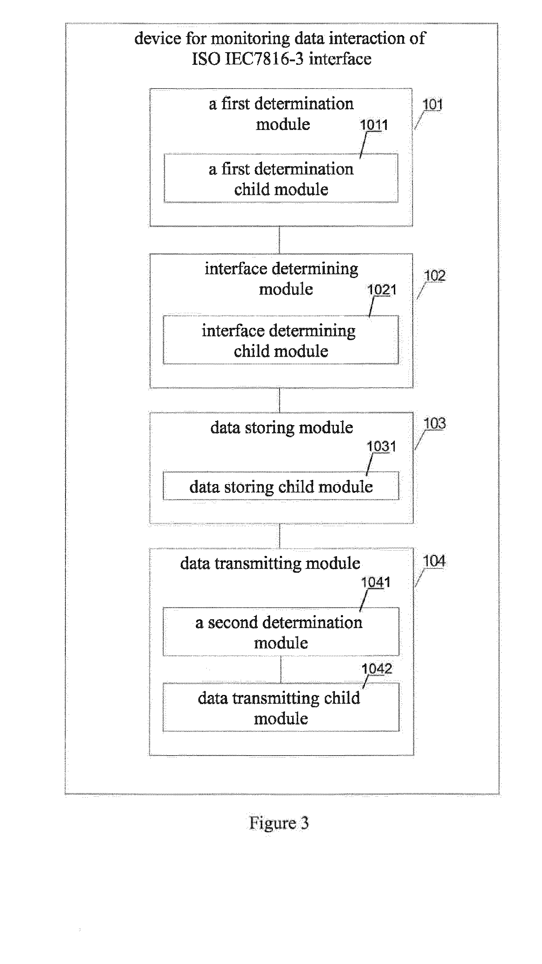

Figure 3 is a structural schematic view of a portable tracker provided by a second embodiment of the invention.

### DETAILED DESCRIPTION

In order to make purposes, technical schemes and advantages of embodiments of the invention more clear, technical schemes in the embodiments of the invention will be clearly and completely described below in conjunction with the embodiments of the invention and drawings. It is necessary to illustrate that the described embodiments are only several embodiments of the invention not all embodiments. All other embodiments obtained by those ordinary skilled in the art based on the embodiments of the invention under the premise that no creative work is done all belong to the protection scope of the invention.

The embodiments of the invention are illustrated below in conjunction with drawings.

### First embodiment

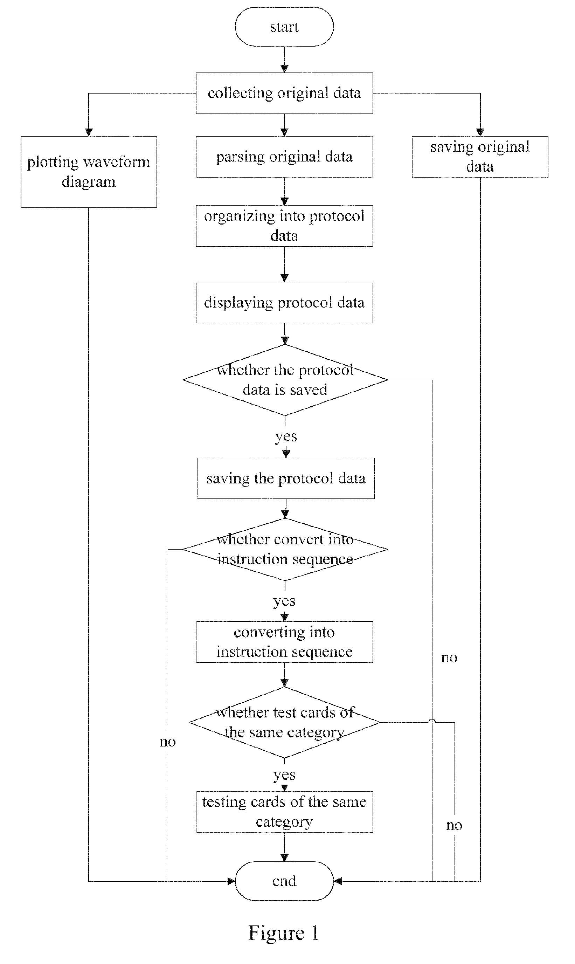

Reference is made to Figure 1 which is a flowchart of a method for tracing and processing smart card interactive data provided by the present embodiment. The method includes the following steps:
Step 1 collection rule of smart card original interactive data is set. Original interactive data of respective contacts VCC/IO/RST/CLK of smart card is monitored and collected through a portable tracker. Data of VCC contact includes jump direction of VCC signal and cumulative time value. Data of IO contact includes jump direction of IO signal, category in which smart card falls in (category A/B/C card), number of sustaining CLK and cumulative time value. Data of RST contact includes jump direction of RST signal and cumulative time value. Data of CLK contact includes jump direction of CLK signal, identification of the start and failure of oscillation and cumulative time value.
Step 2 based on the above collected original interactive data, the following tasks in three aspects are simultaneously done by the use of multi-threaded programming technique.
   2.1 In order that the present tracing process can be recurred, the collected original interactive data is automatically incrementally saved in the form of binary file.
   2.2 According to the rule of ISO/IEC 7816-3, the collected original interactive data is parsed into smart card communication protocol byte stream of significance by calling an original data parsing module, and scattered communication protocol byte stream is organized into easily understood communication protocol data sequence through a protocol data organizing module and subsequent corresponding processing is done.
   2.3 The original interactive data is plotted respectively in terms of VCC/IO/RST/CLK into waveform diagram by using computer graphics API and is displayed in the waveform diagram display area of the soft system of the invention, and communication protocol byte is written in the corresponding location of the waveform diagram.

For the above 2.2, specifically, it further includes the following steps:
2.2.1 Firstly, according to the rule of ISO/IEC 7816-3, the original interactive data is parsed into significant but scattered communication protocol byte stream by calling original data parsing module.
2.2.2 Then according to the rule of ISO/IEC 7816-3, the scattered communication protocol byte stream is organized into easily understood communication protocol data sequence for workers in this industry by calling protocol data organizing module and is displayed in the protocol data display area of the soft system of the invention.
2.2.3 When the tracing and parsing of the interactive data are finished, it is determined whether there is a need to save the communication protocol data sequence, if there is no such need, the current tracing is terminated, if there is such a need, it is saved as text file. It is continuously determined whether there is a need to convert the protocol data sequence into smart card instruction sequence, if there is no such need, the current tracing is terminated, if there is such a need, the protocol data sequence is converted into smart card instruction sequence and is saved for subsequent use. It is continuously determined whether there is a need to test cards of the same category, if there is no such need, the current tracing is terminated, if there is such a need, repetitious or reiterative test is performed on the cards of the same category for achievement of test function. As such, time spent in tracing and analyzing interactive data of each card may be saved and efficiency is improved. The converted instruction sequence may also be sent to other skilled in local or foreign having no tracker for a rapid test of cards of the same category.

In order to further analyze and solve problems, besides analyzing the above protocol data sequence or smart card instruction sequence, jump condition of the direction of VCC/IO/RST/CLK at some point or within a certain period of time, elementary time unit (ETU) condition and the like may also be viewed in conjunction with waveform diagram to further analyze and determine and thus scientifically analyze and solve problems. The waveform diagram is plotted by using Windows API. The abscissa is cumulative time value in the collected original data of respective contacts, and the ordinate is voltage value.

In practical application, the step in which original interactive data of respective contacts VCC/IO/RST/CLK of smart card is monitored and collected according to Step 1 is not totally disjointed with the subsequent step Step 2 in terms of time. After monitoring and collecting original interactive data of respective contacts VCC/IO/RST/CLK of smart card by using portable tracker, each step of Step 2 may be performed based on the those collected original interactive data. Then, original interactive data is collected while the just collected original interactive data is processed based on each step according to Step 2.

Generally, after field technical support person find problems, using portable tracker and the software system according to the invention to trace and analyze interactive data may not only feed back the traced protocol data sequence or smart card instruction sequence to product developer but also may feed back the above automatically saved original data to product developer. The product developer may have no support of hardware equipment, tracker, and by loading original trace data into the software system according to the invention the product developer can obtain protocol data sequence or smart card instruction sequence, waveform diagram of respective contacts VCC/IO/RST/CLK of smart card through analysis and process of the software system thus achieving the aim of completely recreating field test to better analyze and solve problems.

A system for realizing the above method for tracing and processing smart card interactive data includes:
a portable tracker used for monitoring and collecting original interactive data of respective contacts VCC/IO/RST/CLK of smart card;
an original data parsing module used for parsing the original data into smart card communication protocol byte stream of significance;
a waveform diagram plotting module used for plotting waveform diagram of smart card interactive data based on the original interactive data and displaying it;
a smart card protocol data organizing module used for organizing the communication protocol byte stream into easily understood communication protocol data sequence;
a protocol data displaying module used for displaying the protocol data sequence to users of the system;
an interactive data saving module used for saving the original interactive data and the communication protocol data sequence;
a protocol data converting module used for converting the communication protocol data sequence into smart card instruction sequence;
an instruction sequence performing module used for performing the smart card instruction sequence and rapidly testing cards of the same category.

The portable tracker is particularly used for setting collection rule of smart card original interactive data, and monitoring and collecting original interactive data of respective contacts VCC/IO/RST/CLK of smart card. Data of VCC contact includes jump direction of VCC signal and cumulative time value. Data of IO contact includes jump direction of IO signal, category in which smart card falls in (category A/B/C card), number of sustaining CLK and cumulative time value. Data of RST contact includes jump direction of RST signal and cumulative time value. Data of CLK contact includes jump direction of CLK signal, identification of the start and failure of oscillation and cumulative time value.

The waveform diagram plotting module is particularly used for plotting original interactive data respectively in terms of VCC/IO/RST/CLK into waveform diagram and displaying waveform diagram in the waveform diagram display area of the soft system of the invention, and writing communication protocol byte in the corresponding location of the waveform diagram.

Further included is a save module used for incrementally saving the original interactive data in the form of binary file.

Further included are a first determination module used for determining whether there is a need to save the communication protocol data sequence, if there being no such need, current tracing being terminated, if there being such a need, the communication protocol data sequence being saved as text file by the interactive data saving module; a second determination module used for determining whether there is a need to convert protocol data sequence into smart card instruction sequence, if there being no such need, current tracing being terminated, if there being such a need, protocol data sequence being converted into smart card instruction sequence by the protocol data converting module and being saved for subsequent use; a third determination module used for determining whether there is a need to test cards of the same category, if there being no such need, current tracing being terminated, if there being such a need, the smart card instruction sequence is performed by the instruction sequence performing module and cards of the same category being rapidly tested.

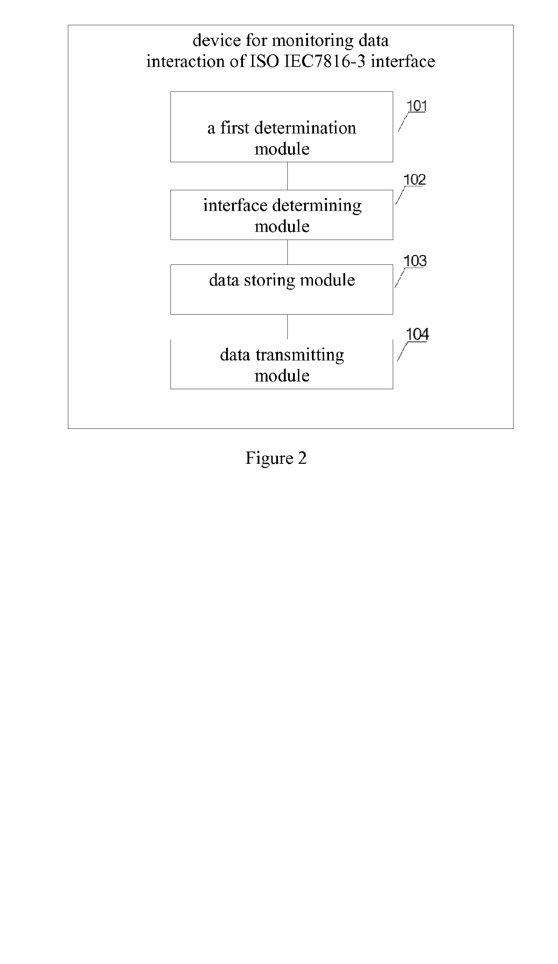

Reference is made to Figure 2 which is a structural schematic view of a portable tracker provided by the present embodiment and applied in processor. This portable tracker may includes a first determination module 101, an interface determining module 102, a data storing module 103 and a data transmitting module 104.

The first determination module 101 is used for determining whether a data collecting request is received and thus a first determination result is obtained. The data collecting request is corresponding to 7816 interface whose signal has a variation for requesting the processor to perform a data collection on the 7816 interface whose interface signal has a variation.

The 7816 interfaces in the present embodiment include a voltage interface 7816_VCC, a clock interface 7816_CLK, a reset interface 7816_RST and a data input output interface 7816_IO.

The interface determining module 102 is used for determining 7816 interface required to be performed a data collection through data collecting request when the first determination result indicates that data collecting request is received to cause the data collecting module to collect data from the determined 7816 interface.

The data storing module 103 is used for storing data collected by the data collecting module from the determined 7816 interface.

The data transmitting module 104 is used for transmitting the stored data to terminal equipment to cause the terminal equipment to process the data.

In the portable tracker used for monitoring data interaction ISOIEC7816-3 interfaces provided by the present embodiment, when the signal of 7816 interfaces has variation, data collecting request can be received, and 7816 interface required to be performed a data collection is determined through data collecting request, thus causing the data collecting module to collect data from the determined 7816 interface, and then the data collected by the data collecting module from the determined 7816 interface is stored, and the stored data is transmitted to terminal equipment to cause terminal equipment to process the data. The portable tracker used for monitoring data interaction of ISOIEC7816-3 interfaces provided by the present embodiment may monitor may monitor the voltage interface 7816_VCC, the clock interface 7816_CLK, the reset interface 7816_RST and the data input output interface 7816_IO of 7816-3.

### Second embodiment

The present embodiment is substantially similar to the first embodiment and these two embodiments are different only in the following aspects.

Reference is made to Figure 4 which is a structural schematic view of a portable tracker provided by the second embodiment and applied in processor. This portable tracker may include a first determination module 101, an interface determining module 102, a data storing module 103 and a data transmitting module 104.

The determination module 101 is used for determining whether a data collecting request is received and a first determination result is obtained. The data collecting request is corresponding to 7816 interface whose signal has a variation for requesting the processor to perform a data collection on the 7816 interface whose interface signal has a variation.

In the present embodiment, 7816 interfaces include a voltage interface 7816_VCC, a clock interface 7816_CLK, a reset interface 7816_RST and a data input output interface 7816_IO. The data collecting request may be an interrupt request sent by the universal input output interface GPIO of the processor to the processor when the levels of 7816 interfaces have variations.

Further, the first determination module 101 includes a first determination child module 1011. The first determination child module 1011 is used for determining whether the interrupt request from GPIO of the processor is received and thus a first determination result is obtained.

The interface determining module 102 is used for determining 7816 interface required to be performed a data collection through data collecting request when the first determination result indicates that data collecting request is received to cause the data collecting module to collect data from the determined 7816 interface.

Further, the interface determining module 102 includes an interface determining child module 1021. The interface determining child module 1021 is used for determining 7816 interface required to be performed a data collection through the interrupt request of GPIO when the first determination result indicates that the interrupt request from GPIO of the processor is received.

The data storing module 103 is used for storing data collected by the data collecting module from the determined 7816 interface.

In the present embodiment, inside the processor there is provided with a storage space serving to provide buffering for data transmission. Further, the data storing module 103 includes a data storing child module 1031. The data storing child module 1031 is used for storing the data collected by the data collecting module from the determined 7816 interface into the storage space provided in the processor serving to provide buffering for data transmission.

The data transmitting module 104 is used for transmitting the stored data to terminal equipment to cause the terminal equipment to process the data.

Further, the data transmitting module 104 includes a second determination child module 1041 and a data transmitting child module 1042. The second determination child module 1041 is used for determining whether there is data that has not been transmitted in the storage space provided in the processor serving to provide buffering for data transmission and thus a second determination result is obtained. The data transmitting child module 1042 is used for transmitting the data that has not been transmitted in the storage space to the terminal equipment when the second determination result indicates that there is data that has not been transmitted in the storage space.

The method and system for tracing and processing smart card interactive data provided by embodiments of the invention may rapidly find problems. The portable tracker can solve the problem that the method used in the prior art for monitoring data interaction of interfaces of ISOIEC7816-3 can only monitor the data of 7816-CLK interface and 7816-IO interface thus incompleteness of the collected data significantly influences the subsequent analysis and processing of data.

Compared with the prior art, the invention has the following advantages:
After field technical support person find problems, using portable tracker and the method according to the invention to trace and analyze interactive data may not only feed back the traced protocol data sequence or smart card instruction sequence to product developer but also may feed back the above automatically saved original data to product developer. The product developer may have no support of hardware equipment, tracker, and by loading original trace data into the method according to the invention , the product developer can obtain protocol data sequence or smart card instruction sequence, waveform diagram of respective contacts VCC/IO/RST/CLK of smart card through automatic analysis and process thus achieving the aim of completely recreating field test to better analyze and solve problems.

The data collected through the portable tracker provided by the invention is more complete, more fully and can more truly reflect the state of interfaces which is beneficial to the analysis and process of the subsequent data. In addition, the collected data being stored into the storage space provided in the processor serving to provide buffering for data transmission causes the transmission speed of data to be improved.

The above embodiments only express one embodiment of the invention and the description thereof is more specific and detailed, but it cannot be understood as a limitation to the scope of the invention. It should be noted that several variations and improvements may also be made for those skilled in the art under the premise that the concept of the invention is not departed which all belong to the protection scope of the invention. Therefore, the protection scope of the invention should be subject to the appendent claim.

## Claims

1. A method for tracing and processing smart card interactive data, comprising the following steps:
S1. monitoring and collecting original interactive data of respective contacts VCC/IO/RST/CLK of smart card;
S2. parsing the original data into smart card communication protocol byte stream;
S3. organizing the communication protocol byte stream into communication protocol data sequence;
S4. displaying the protocol data sequence to users of system;
S5. saving the communication protocol data sequence;
S6. converting the communication protocol data sequence into smart card instruction sequence;
S7. performing the smart card instruction sequence, rapidly testing cards of the same category and then terminating current tracing;
Between the S1 and the termination of current tracing, there being further comprised the following two simultaneously performed tasks:
Sm. plotting waveform diagram of smart card interactive data based on the original interactive data and displaying it;
Sn. incrementally saving the original interactive data.

2. The method according to claim 1, wherein the S1 comprises setting collection rule of smart card original interactive data, monitoring and collecting original interactive data of respective contacts VCC/IO/RST/CLK of smart card, and wherein data of VCC contact comprises jump direction of VCC signal and cumulative time value, data of IO contact comprises jump direction of IO signal, category in which smart card falls in (category A/B/C card), number of sustaining CLK and cumulative time value, data of RST contact comprises jump direction of RST signal and cumulative time value, and data of CLK contact comprises jump direction of CLK signal, identification of the start and failure of oscillation and cumulative time value.

3. The method according to claim 1, wherein the Sm comprises plotting the original interactive data respectively in terms of VCC/IO/RST/CLK into waveform diagram and displaying it in waveform diagram display area, and writing communication protocol byte in the corresponding location of the waveform diagram.

4. The method according to claim 1, wherein the Sn comprises incrementally saving the original interactive data in the form of binary file.

5. The method according to claim 1, wherein the S5 particularly comprises determining whether there is a need to save the communication protocol data sequence, if there being no such need, terminating current tracing, if there being such a need, saving it as text file, the S6 particularly comprises determining whether there is a need to convert protocol data sequence into smart card instruction sequence, if there being no such need, terminating current tracing, if there being such a need, converting protocol data sequence into smart card instruction sequence and saving it for subsequent use, and the S7 particularly comprises determining whether there is a need to test cards of the same category, if there being no such need, terminating current tracing, if there being such a need, performing the smart card instruction sequence and rapidly testing cards of the same category.

6. A system for tracing and processing smart card interactive data comprising:
a portable tracker used for monitoring and collecting original interactive data of respective contacts VCC/IO/RST/CLK of smart card;
an original data parsing module used for parsing the original data into smart card communication protocol byte stream of significance;
a waveform diagram plotting module used for plotting waveform diagram of smart card interactive data based on the original interactive data and displaying it;
a smart card protocol data organizing module used for organizing the communication protocol byte stream into easily understood communication protocol data sequence;
a protocol data displaying module used for displaying the protocol data sequence to users of the system;
a communication protocol data sequence saving module used for saving the communication protocol data sequence;
an interactive data saving module used for incrementally saving the original interactive data;
a protocol data converting module used for converting the communication protocol data sequence into smart card instruction sequence;
an instruction sequence performing module used for performing the smart card instruction sequence and rapidly testing cards of the same category.

7. The system according to claim 6, wherein the portable tracker is particularly used for setting collection rule of smart card original interactive data, and monitoring and collecting original interactive data of respective contacts VCC/IO/RST/CLK of smart card, wherein data of VCC contact comprises jump direction of VCC signal and cumulative time value, data of IO contact comprises jump direction of IO signal, category in which smart card falls in (category A/B/C card), number of sustaining CLK and cumulative time value, data of RST contact comprises jump direction of RST signal and cumulative time value, and data of CLK contact comprises jump direction of CLK signal, identification of the start and failure of oscillation and cumulative time value.

8. The system according to claim 6, wherein the waveform diagram plotting module is particularly used for plotting original interactive data respectively in terms of VCC/IO/RST/CLK into waveform diagram and displaying waveform diagram in the waveform diagram display area of the soft system of the invention, and writing communication protocol byte in the corresponding location of the waveform diagram.

9. The system according to claim 6, wherein the original interactive data saving module is particularly used for incrementally saving the original interactive data in the form of binary file.

10. The system according to claim 6, wherein further comprised are a first determination module used for determining whether there is a need to save the communication protocol data sequence, if there being no such need, current tracing being terminated, if there being such a need, the communication protocol data sequence being saved as text file by the interactive data saving module, a second determination module used for determining whether there is a need to convert protocol data sequence into smart card instruction sequence, if there being no such need, current tracing being terminated, if there being such a need, protocol data sequence being converted into smart card instruction sequence by the protocol data converting module and being saved for subsequent use, and a third determination module used for determining whether there is a need to test cards of the same category, if there being no such need, current tracing being terminated, if there being such a need, the smart card instruction sequence is performed by the instruction sequence performing module and cards of the same category being rapidly tested.

11. The system according to claim 6, wherein the portable tracker comprises:
a first determination module used for determining whether a data collecting request is received and thus a first determination result being obtained, wherein the data collecting request is corresponding to 7816 interface whose signal has a variation for requesting the processor to perform a data collection on the 7816 interface whose signal has a variation;
an interface determining module used for determining 7816 interface required to be performed a data collection through the data collecting request when the first determination result indicates that data collecting request is received to cause data collecting module to collect data from the determined 7816 interface;
a data storing module used for storing data collected by the data collecting module from the determined 7816 interface;
a data transmitting module used for transmitting the stored data to terminal equipment to cause the terminal equipment to process the data.

12. The system according to claim 11, wherein the data collecting request is an interrupt request sent by the universal input output interface GPIO of the processor to the processor when levels of 7816 interfaces have variations, the first determination module comprises a first determination child module used for determining whether interrupt request from GPIO of the processor is received and thus a first determination result being obtained, and the interface determining module comprises an interface determining child module used for determining 7816 interface required to be performed a data collection through the interrupt request of GPIO when the first determination result indicates that the interrupt request from GPIO of the processor is received.

13. The system according to claim 11, wherein inside the processor there is provided with a storage space serving to provide buffering for data transmission, and the data storing module comprises a data storing child module used for storing the data collected by the data collecting module from the determined 7816 interface into the storage space provided in the processor serving to provide buffering for data transmission.

14. The system according to claim 11, wherein the data transmitting module comprises a second determination child module used for determining whether there is data that has not been transmitted in the storage space and thus a second determination result being obtained and a data transmitting child module used for transmitting the data that has not been transmitted in the storage space to terminal equipment when the second determination result indicates that there is data that has not been transmitted in the storage space.
